(19) Europäisches Patentamt / European Patent Office / Office européen des brevets

(11) **EP 3 360 255 B1**

(12) **EUROPEAN PATENT SPECIFICATION**

(45) Date of publication and mention
of the grant of the patent:
**21.04.2021 Bulletin 2021/16**

(21) Application number: **15816735.3**

(22) Date of filing: **16.12.2015**

(51) Int Cl.:
*H03M 1/10* (2006.01)   *H03M 1/46* (2006.01)
*H03M 1/06* (2006.01)   *H03M 1/80* (2006.01)

(86) International application number:
**PCT/EP2015/080079**

(87) International publication number:
**WO 2017/101998 (22.06.2017 Gazette 2017/25)**

(54) **CALIBRATABLE DATA CONVERTER**

KALIBRIERBARER DATENWANDLER

CONVERTISSEUR DE DONNÉES ÉTALONNABLE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**15.08.2018 Bulletin 2018/33**

(73) Proprietor: **Huawei Technologies Co., Ltd.
Longgang District
Shenzhen, Guangdong 518129 (CN)**

(72) Inventor: **ZARE HOSEINI, Hashem
80992 Munich (DE)**

(74) Representative: **Gill Jennings & Every LLP
The Broadgate Tower
20 Primrose Street
London EC2A 2ES (GB)**

(56) References cited:
**DE-B3-102014 200 624    US-A1- 2010 079 327
US-A1- 2013 076 546**

**Description**

TECHNICAL FIELD

The present disclosure relates to a calibratable data converter, in particular to a calibratable Analog-to-Digital Converter (ADC), in particular to a Successive Approximations Register (SAR) ADC. The disclosure further relates to a method for calibrating an ADC, in particular a SAR ADC.

BACKGROUND

High performance ADCs are required for the next generation of telecommunications (4.5G, 5G), WiFi, wired and wireless telecommunications. In such applications, high speed requirements dictate utilizing Successive Approximations Register (SAR) ADCs in Time Interleaved (TI) fashion as the main choice in order to achieve higher speed while maintaining relatively low power consumption. On the other hand, SAR ADCs are also widely used for low-power applications where 10-14 bit resolution is needed. Capacitor mismatch in the high resolution SAR ADCs becomes one of the main challenges when the resolution goes beyond 10-11 bit. For higher resolutions, mismatch causes missing codes, integral nonlinearity (INL) and differential nonlinearity (DNL) problems and hence a lower effective number of bits (ENOB). A trivial solution is to increase the size of unit capacitance for better matching but it comes with the price of the area and power consumption especially in high speed applications. There are several methods to overcome the capacitor mismatch problem by measuring the errors and then compensate them in analog or digital domain. In majority of the solutions, a predefined input such as Sine or Ramp signals are used to measure the errors. Another method is to use a very accurate auxiliary Digital-to-Analog Converter (DAC) to generate a defined analog input where the SAR ADC is calibrated against. Yet another method is to use a very high resolution ADC such as delta-sigma to measure the errors of the capacitive DAC inside the SAR ADC. The above solutions are either impractical for production testing or very expensive in terms of area and power consumption. Calibratable SAR ADCs are known from US 2013/076546 A1, US 2010/079326 A1 and DE 10 2014200624 B3.

SUMMARY

It is the object of the invention to provide a design technique for an ADC that consumes low silicon area and generates an accurate digital signal and/or to improve calibration of an ADC.
This object is achieved by the features of the independent claims. Further implementation forms are apparent from the dependent claims, the description and the figures.
A basic idea of the invention is to use the same ADC for error measurements, thus no external components are required. As the mismatch error is small, only few least significant bits (LSBs) of the ADC are used for measurement. Hence, measurements are accurate. Correction in digital domain is achieved by adjusting the weighting coefficients by using redundancy steps. The mismatch is measured by observing only few most significant bit (MSB) capacitors. The capacitor mismatch in MSB capacitors is higher (and hence more critical) than the mismatch in LSB capacitors of the same ADC. This can be shown by writing the Gaussian distribution of the mismatch errors between the capacitors. Hence, by calculating the MSBs mismatch and then calibrating in digital domain, the effective resolution of the ADC is increased.
When using the disclosed technique, the mismatch errors on a few highest MSB capacitors of the ADC are obtained and digitized by using the same ADC but with only few of its LSBs. In this method, neither external predefined inputs such as ramps are needed nor a high quality auxiliary ADC is used. The same ADC is used, i.e. any errors such as reference variations, gain, capacitive loadings etc. will not affect the calibration process. Fast calibration can be achieved because only a few cycles are required for calibration. No external components are needed, hence semiconductor area consumption and design effort are minimal. No external known signal is needed which is very suitable for commercial and industrial products.
In order to describe the invention in detail, the following terms, abbreviations and notations will be used:

ADC: Analog-to-Digital Converter
DAC: Digital-to-Analog Converter
SAR: Successive Approximations Register
LSB: Least Significant Bit
MSB: Most Significant Bit
ENOB: effective number of bits
INL: integral nonlinearity
DNL: differential nonlinearity

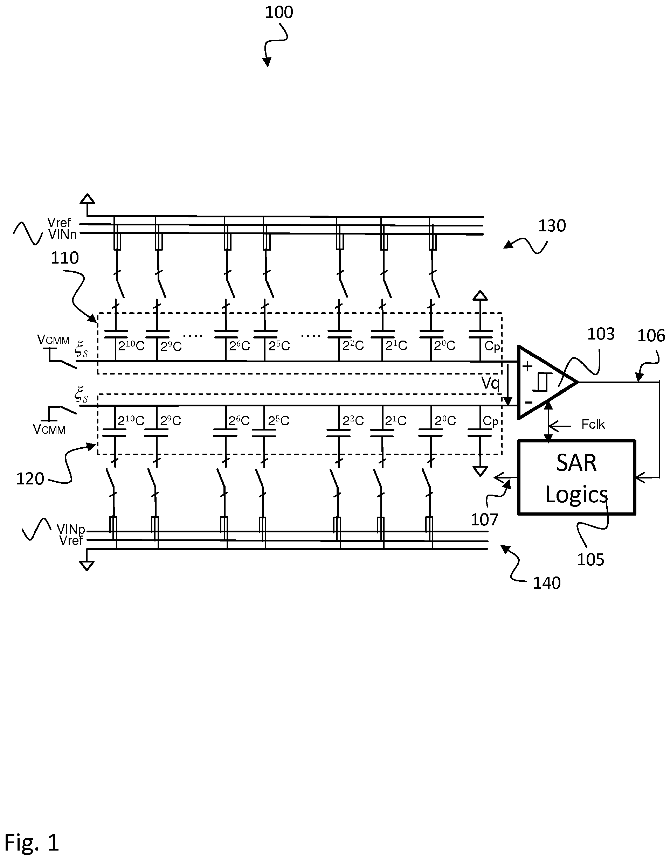

Techniques according to the disclosure may be applied for designing SAR ADCs, e.g. as depicted in Fig. 1. Successive-approximation-register (SAR) analog-to-digital converters (ADCs) are frequently used for medium-to-high-resolution applications with sample rates under tens of megasamples per second (Msps). Resolution for SAR ADCs most commonly ranges from 8 to 16 bits and they provide low power consumption The SAR ADC basically implements a binary search algorithm. Therefore, while the internal circuitry may be running at several megahertz (MHz), the ADC sample rate is a fraction of that number due to the successive-approximation algorithm.

The basic architecture of a SAR ADC is shown in Fig. 1. The SAR ADC includes a first capacitor line 110 and a second capacitor line 120 which are each connected to a respective terminal of a comparator 103. The capacitor lines 110, 120 implement capacitive DACs and each one includes an array of N capacitors with binary weighted values. Cp denotes the parasitic capacitance on the input of the comparator Fig. 1 shows an example of a 12-bit capacitive DAC connected to a comparator 103. During the acquisition phase, the array's common terminal (the terminal at which all the capacitors share a connection, see Figure 1) is connected to VCMM where VCMM is a common-mode voltage and all free terminals are connected to the input signal (analog in or VIN). After acquisition, the common terminal is disconnected from VCMM and the free terminals are disconnected from VIN, thus effectively trapping a charge proportional to the input voltage on the capacitor array. The free terminals of all the capacitors are then connected to ground, driving the terminal of 110 to VCMM-VINn and the terminal of 120 to VCMM-VINp. Hence the input of the comparator is Vq=VIN=VINp-VINn..

As the first step in the binary search algorithm, the input of the comparator Vq = VIN. The comparator output 106 yields a logic 1 if Vq > 0 (i.e., VIN > 0). The comparator output 106 yields logic 0 if VIN < 0. If the comparator output 106 at the end of the first step is logic 1, at the second step in the binary search algorithm, the bottom plate of the MSB capacitor in 120 is disconnected from ground and connected to VREF. This drives the comparator input in the negative direction by an amount equal to -½VREF. Therefore, Vq = VIN - ½ × VREF. The comparator output 106 yields a logic 1 if VCOMMON > 0 (i.e., VIN > ½ × VREF). The comparator output 106 yields logic 0 if VIN < ½ × VREF.

Alternatively, if the comparator output 106 at the end of the first step is logic 0, at the second step in the binary search algorithm, the bottom plate of the MSB capacitor in 110 is disconnected from ground and connected to VREF. This drives the comparator input in the positive direction by an amount equal to +½VREF. Therefore, Vq = VIN + ½ × VREF. The comparator output 106 yields a logic 1 if Vq > 0 (i.e., VIN >- ½ × VREF). The comparator output 106 yields logic 0 if VIN <- ½ × VREF.

Same procedure is repeated for the bottom plate of the next smaller capacitors until all the bits have been determined. In general, the input of the comparator converges to zero i.e. Vq will be almost zero at the end of the comparison time.

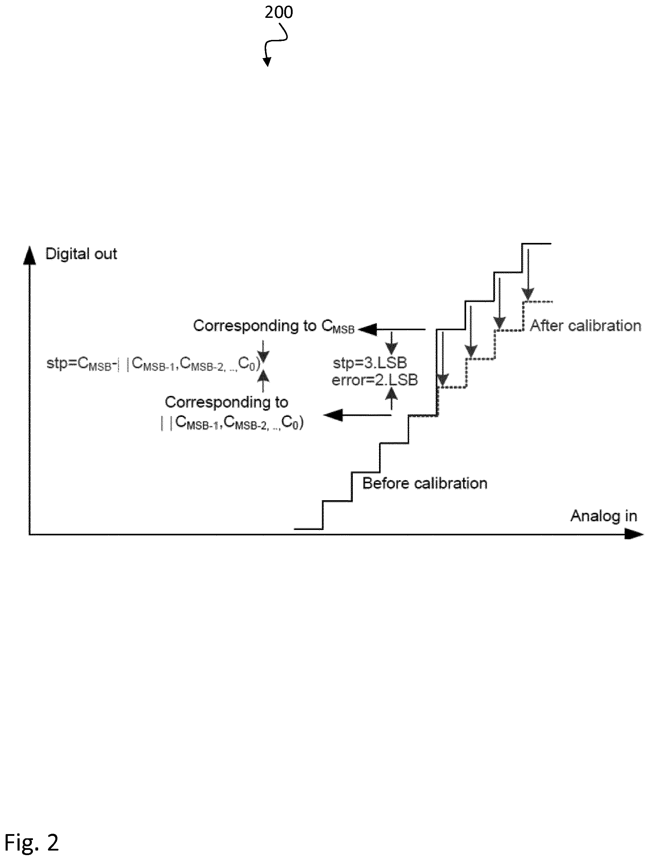

Techniques according to the disclosure may be applied for reducing mismatch errors in ADCs, e.g. mismatch errors 200 as depicted in Fig. 2.

Mismatch is defined as the error between a capacitor generating code $2^m$ and the entire capacitors generating code $2^{m-1}$. In a binary ADC, the error of each capacitor is the mismatch between that capacitor and the total capacitors in previous steps combined as can be seen from Figure 2.

According to a first aspect, the invention relates to a calibratable Analog-to-Digital Converter (ADC), comprising: a comparator; a first capacitor line comprising a plurality of capacitances coupled in parallel to a first input terminal of the comparator; a second capacitor line comprising a plurality of capacitances coupled in parallel to a second input terminal of the comparator; and a controller configured: to drive a first part of the first capacitor line with a first voltage pattern and a corresponding first part of the second capacitor line with a second voltage pattern in order to sample the voltage patterns to the capacitors of the first part of the first capacitor line and the corresponding first part of the second capacitor line respectively, to drive the first part of the first capacitor line with a second voltage pattern and the corresponding first part of the second capacitor line with the first voltage pattern in order to generate a comparator input voltage between the input terminals of the comparator, and to adjust a second part of the first capacitor line and a corresponding second part of the second capacitor line in order to capture a residual voltage, which corresponds to the comparator input voltage, as calibration value.

Such a calibratable ADC provides the advantage to obtain the mismatch errors on the few highest MSB capacitors and to digitize them using the same ADC but with only few of its LSBs. By using such technique no external predefined inputs such as a ramp is needed nor a high quality auxiliary ADC has to be used. The capacitor mismatch in MSB capacitors are higher and hence more critical than the ones in LSB capacitors in the same ADC. Hence, if the MSBs mismatch is calculated and then calibrated in digital domain, the effective resolution of the ADC will be increased.

In a first possible implementation form of the calibratable ADC according to the first aspect, the calibratable ADC comprises: a logic circuit coupled to a binary output terminal of the comparator, configured to adjust the second part of the first capacitor line and the corresponding second part of the second capacitor line based on a binary search, in particular based on successive approximation reregistering (SAR).

The binary search algorithm, in particular the SAR architecture provides the advantage of implementation of high-performance, low power ADCs to be packaged in small form factors. The logic circuit can be used for both cases:

the normal operation of the ADC and the calibration of the ADC, thereby reducing complexity in terms of chip size.

In a second possible implementation form of the calibratable ADC according to the first aspect as such or according to the first implementation form of the first aspect, the first part of the first capacitor line comprises a plurality of Most Significant Bit (MSB) capacitors; and the corresponding first part of the second capacitor line comprises a plurality of MSB capacitors.

This provides the advantage that the MSB capacitors can be calibrated by applying the first and second voltage patterns to these MSB capacitors and by determining the residual voltage as the difference between applying the first voltage pattern and the second voltage pattern to the MSB capacitors.

In a third possible implementation form of the calibratable ADC according to the first aspect as such or according to any of the preceding implementation forms of the first aspect, the second part of the first capacitor line comprises a plurality of Least Significant Bit (LSB) capacitors; and the corresponding second part of the second capacitor line comprises a plurality of LSB capacitors.

This provides the advantage that the LSB capacitors of the same ADC can be used to determine the residual voltage which can be used as calibration value. Using the LSB capacitors of the same ADC reduces complexity of the layout of the ADC.

In a fourth possible implementation form of the calibratable ADC according to the first aspect as such or according to any of the preceding implementation forms of the first aspect, both, capacitors of the first capacitor line and capacitors of the second capacitor line are successively arranged in powers of two of a basic capacitance.

This provides the advantage that the calibration can be performed very accurate with the lowest number of capacitive elements which reduces layout complexity of a chip design of the ADC.

In a fifth possible implementation form of the calibratable ADC according to the first aspect as such or according to any of the preceding implementation forms of the first aspect, the first voltage pattern comprises a first reference voltage coupled to at least one capacitor of the first part of the first capacitor line and a second reference voltage coupled to at least one other capacitor of the first part of the first capacitor line.

This provides the advantage that the capacitors of the first capacitor line are driven by different reference voltages such that different voltage components are produced at the comparator's first input, i.e. a specific dynamic voltage range can be controlled by the controller.

In a sixth possible implementation form of the calibratable ADC according to the fifth implementation form of the first aspect, the second voltage pattern comprises the second reference voltage coupled to the at least one capacitor of the corresponding first part of the second capacitor line and the first reference voltage coupled to the at least one other capacitor of the corresponding first part of the second capacitor line.

This provides the advantage that the capacitors of the second capacitor line are driven by different reference voltages such that different voltage components are produced at the comparator's second input, i.e. a specific dynamic voltage range can be controlled by the controller.

In a seventh possible implementation form of the calibratable ADC according to the fifth or the sixth implementation form of the first aspect, the second voltage pattern is an inverse of the first voltage pattern in which the first reference voltage is exchanged with the second reference voltage and vice versa.

This provides the advantage that by using the second voltage pattern as an inverse of the first voltage pattern, a residual voltage can be obtained which should be zero in the ideal case. Therefore, this residual voltage can be used as a calibration value for the non-ideal case.

In an eighth possible implementation form of the calibratable ADC according to the first aspect as such or according to any of the preceding implementation forms of the first aspect, the first part of the first capacitor line comprises a first auxiliary capacitor having a capacitance that is approximately equal to a sum capacitance of capacitors of the second part of the first capacitor line; and the first part of the second capacitor line comprises a second auxiliary capacitor having a capacitance that is approximately equal to a sum capacitance of capacitors of the second part of the second capacitor line.

This provides the advantage that the auxiliary capacitor can used as a replacement for the LSB capacitors which then can be used for measuring the residual voltage, i.e. the calibration value. That means, the same ADC can be used for both, normal operation and calibration. In the normal operation, the auxiliary capacitors are not required and can be switched off.

In a ninth possible implementation form of the calibratable ADC according to the eighth implementation form of the first aspect, the first auxiliary capacitor and the second auxiliary capacitor are redundancy step capacitors for utilization as redundancy steps in a normal operation of the ADC when the ADC is calibrated.

This provides the advantage that these auxiliary capacitors extend the dynamic of the search algorithm a bit higher than references in the SAR ADCs so that if there is an error in comparison in the MSBs, the search algorithm still converges using the redundant step.

In a tenth possible implementation form of the calibratable ADC according to any of the fifth to the ninth implementation forms of the first aspect, the first capacitor line further comprises a third part of MSB capacitors which are coupled to the second reference voltage; and the second capacitor line further comprises a corresponding third part of MSB capacitors which are coupled to the second reference voltage.

This provides the advantage that calibration can be flexibly applied to a subset of the MSB capacitors of both capacitor lines.

In an eleventh possible implementation form of the calibratable ADC according to the tenth implementation form of the first aspect, the controller is further configured to: assign an MSB capacitor from the third part of the first capacitor line to the first part of the first capacitor line; assign an MSB capacitor from the third part of the second capacitor line to the first part of the second capacitor line; repeat the driving of the first parts of the first and second capacitor lines with the respective first and second voltage patterns; repeat the adjusting of the second parts of the first and second capacitor lines in order to capture a second residual voltage; and set the calibration value based on the residual voltage and the second residual voltage.

This provides the advantage that the MSB capacitors of the third parts can be iteratively calibrated, i.e. in a first iteration the lowest-valued MSB capacitor is used for calibration and in successive iterations the other MSB capacitors are applied in the calibration process. Applying such an iterative calibration scheme increases the accuracy of the calibration.

In a twelfth possible implementation form of the calibratable ADC according to the eleventh implementation form of the first aspect, the MSB capacitor of the third part assigned to the first part of the first capacitor line is an LSB capacitor with respect to the other MSB capacitors of the third part of the first capacitor line; and the MSB capacitor of the third part assigned to the first part of the second capacitor line is an LSB capacitor with respect to the other MSB capacitors of the third part of the second capacitor line.

This provides the advantage of a step-by-step calibration process resulting in a highly accurate calibration result.

In a thirteenth possible implementation form of the calibratable ADC according to the eleventh or the twelfth implementation form of the first aspect, the controller is further configured to: assign a further MSB capacitor of the third part of the first capacitor line to the first part of the first capacitor line; assign a further MSB capacitor of the third part of the second capacitor line to the first part of the second capacitor line; and repeat the driving of the first parts of the first and second capacitor lines with the respective first and second voltage patterns; repeat the adjusting of the second parts of the first and second capacitor lines in order to capture a third residual voltage; and set the calibration value based on the residual voltage, the second residual voltage and the third residual voltage.

This provides the advantage that the MSB capacitors of the third parts can be iteratively calibrated, i.e. in a second iteration the second-lowest-valued MSB capacitor is used for calibration and in successive iterations the other MSB capacitors are applied in the calibration process. Applying such an iterative calibration scheme increases the accuracy of the calibration.

In a fourteenth possible implementation form of the calibratable ADC according to any of the eleventh to the thirteenth implementation forms of the first aspect, the controller is further configured: to store data generated in each repetition of driving the first parts and adjusting the second parts in a memory; to set the calibration value as a function of the stored data and an offset of the comparator; and to apply the calibration value to a normal operation of the ADC.

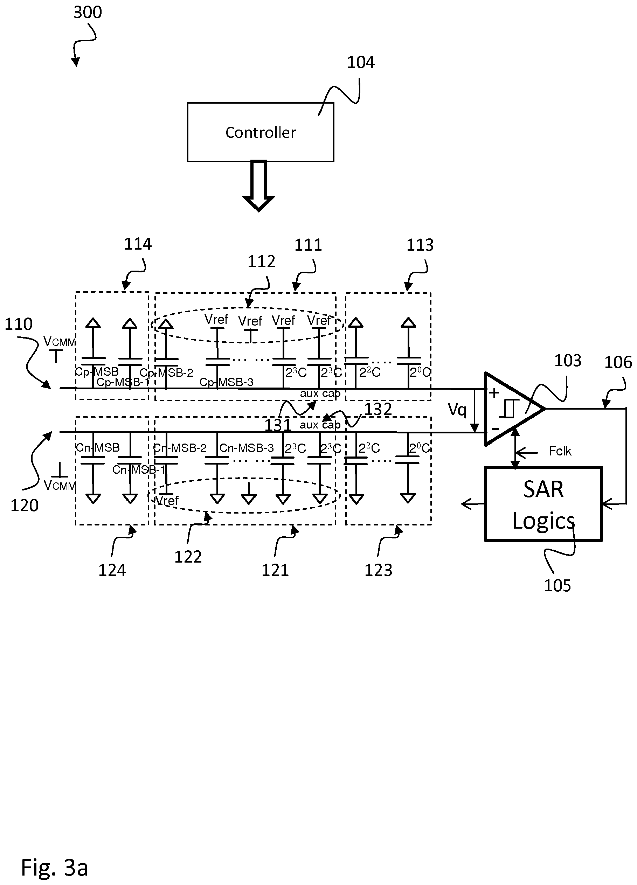

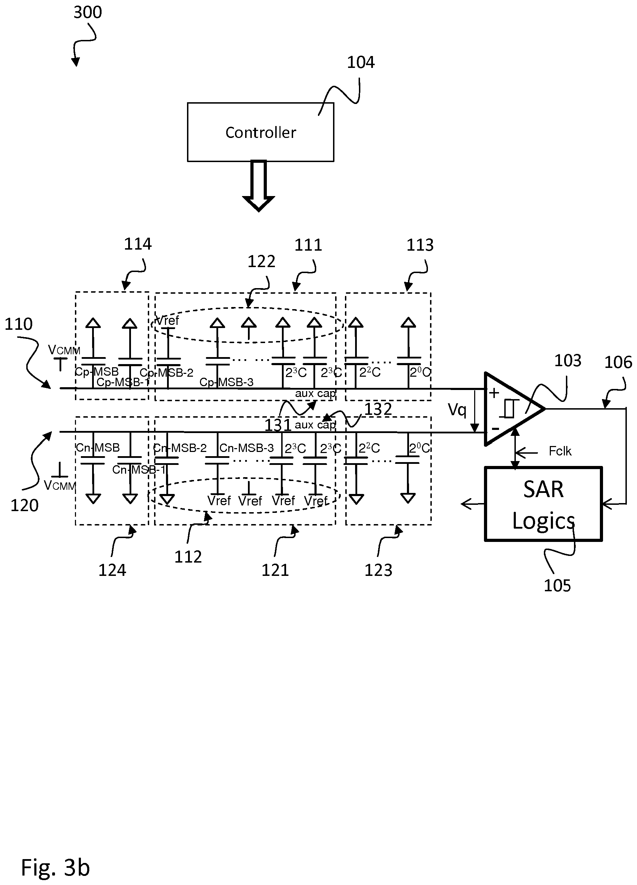

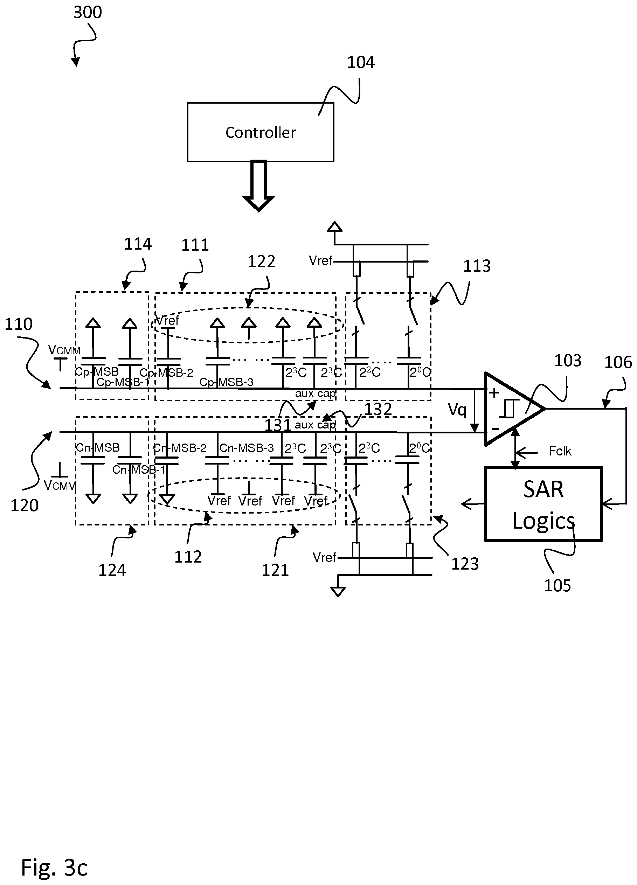

This provides the advantage that a calibration process can be realized over a variety of different calibration stages of the ADC, e.g. calibration stages as described below with respect to Figures 3, 4 and 5 and a calibration result evaluating different calibration stages is more precise than a calibration result of a single calibration stage.

BRIEF DESCRIPTION OF THE DRAWINGS

Further embodiments of the invention will be described with respect to the following figures, in which:

Fig. 1 shows a schematic diagram illustrating a conventional SAR ADC 100;

Fig. 2 shows a schematic diagram illustrating mismatch errors in an ADC;

Fig. 3a shows a block diagram illustrating a calibratable ADC 300 according to a first implementation form during a first calibration phase;

Fig. 3b shows a block diagram illustrating the calibratable ADC 300 during a second calibration phase;

Fig. 3c shows a block diagram illustrating the calibratable ADC 300 during a third calibration phase;

Fig. 4a shows a block diagram illustrating a calibratable ADC 400 according to a second implementation form during a first calibration phase;

Fig. 4b shows a block diagram illustrating the calibratable ADC 400 during a second calibration phase;

Fig. 4c shows a block diagram illustrating the calibratable ADC 400 during a third calibration phase;

Fig. 5a shows a block diagram illustrating a calibratable ADC 500 according to a third implementation form during a first calibration phase;

Fig. 5b shows a block diagram illustrating the calibratable ADC 500 during a second calibration phase;

Fig. 5c shows a block diagram illustrating the calibratable ADC 500 during a third calibration phase; and

Fig. 6 shows a block diagram illustrating a calibratable ADC 600 according to a fourth implementation form during a third calibration phase.

## DETAILED DESCRIPTION OF EMBODIMENTS

In the following detailed description, reference is made to the accompanying drawings, which form a part thereof, and in which is shown by way of illustration specific aspects in which the disclosure may be practiced. The following detailed description is not to be taken in a limiting sense, and the scope of the present disclosure is defined by the appended claims.

Fig. 3a shows a block diagram illustrating a calibratable ADC 300 according to a first implementation form during a first calibration phase.

The ADC 300 includes a comparator 103; a first capacitor line 110 including a plurality of capacitances (Cp capacitances) coupled in parallel to a first input terminal, e.g. a positive input + of the comparator 103; a second capacitor line 120 including a plurality of capacitances (Cn capacitances) coupled in parallel to a second input terminal, e.g. a negative input - of the comparator (103); and a controller 104.

The controller 104 drives a first part 111 of the first capacitor line 110 with a first voltage pattern 112 and a corresponding first part 121 of the second capacitor line 120 with a second voltage pattern 122 in order to sample the voltage patterns to the capacitors of the first part 111 of the first capacitor line 110 and the corresponding first part 121 of the second capacitor line 120 respectively.

The first voltage pattern 112 includes a first reference voltage Vref coupled to LSB capacitors of the first part 111 of the first capacitor line 110 and a second reference voltage Vgnd coupled to the MSB capacitor of the first part 111 of the first capacitor line 110. The second reference voltage Vgnd is coupled to the corresponding LSB capacitors of the corresponding first part 121 of the second capacitor line 120 and the first reference voltage Vref is coupled to the corresponding MSB capacitor of the corresponding first part 121 of the second capacitor line 120. In the implementation shown in Figure 3a, the second voltage pattern 122 is an inverse of the first voltage pattern 112 in which the first reference voltage Vref is exchanged with the second reference voltage Vgnd and vice versa. In other implementation forms of the ADC, other relations between the second voltage pattern 122 and the first voltage pattern 112 are realized.

The first part 111 of the first capacitor line 110 includes a first auxiliary capacitor 131. A capacitance of the first auxiliary capacitor 131 is approximately equal to a sum capacitance of capacitors of the second part 113 of the first capacitor line 110. Correspondingly, the first part 121 of the second capacitor line 120 includes a second auxiliary capacitor 132. A capacitance of the second auxiliary capacitor 132 is approximately equal to a sum capacitance of capacitors of the second part 123 of the second capacitor line 120. In the normal operation, the auxiliary capacitors 131, 132 are not required and can be switched off.

The first auxiliary capacitor 131 and the second auxiliary capacitor 132 are redundancy step capacitors for utilization as redundancy steps in a normal operation of the ADC 300, i.e. when the ADC 300 is calibrated. Redundancy steps are used to extend the dynamic of the search algorithm a bit higher than References in the SAR ADCs so that if there is an error in comparison in the MSBs, the search algorithm still converges using the redundant step. Redundancy is utilized in the normal operation of this ADC after the calibration is done.

The first capacitor line 110 further includes a third part 114 of MSB capacitors which are coupled to the second reference voltage Vgnd. Accordingly, the second capacitor line 120 further includes a corresponding third part 124 of MSB capacitors which are coupled to the second reference voltage Vgnd.

When the first part 111 of the first capacitor line 110 is driven with the first voltage pattern 112 and the corresponding first part 121 of the second capacitor line 120 is driven with the second voltage pattern 122, the capacitors Cp-MSB, Cp-MSB-1 of the third part 114 of the first capacitor line 110 and the capacitors Cn-MSB, Cn-MSB-1 of the corresponding third part 124 of the second capacitor line 120 are connected to a common voltage called VCMM via a switch (not illustrated in the figure) in order to sample the voltage patterns 112, 122 to the capacitors on the first parts 111, 121.

In the exemplary implementation of Fig. 3a, the first voltage pattern 112 includes a first reference voltage Vref that is coupled to capacitors Cp-MSB-3 to $2^3$ C and additionally to auxiliary capacitor $2^3$ C, 131. The first voltage pattern 112 further includes a second reference voltage, in this implementation the Ground voltage that is coupled to capacitor Cp-MSB-2. The second voltage pattern 122 includes the second reference voltage, in this implementation the Ground voltage that is coupled to capacitors Cn-MSB-3 to $2^3$ C and additionally to auxiliary capacitor $2^3$ C, 132. The second voltage pattern 122 further includes the first reference voltage Vref that is coupled to capacitor Cn-MSB-2.

The first part 111 of the first capacitor line 110 includes a plurality of Most Significant Bit (MSB) capacitors and the corresponding first part 121 of the second capacitor line 120 includes a plurality of MSB capacitors. The second part 113 of the first capacitor line 110 includes a plurality of Least Significant Bit (LSB) capacitors and the corresponding second part 123 of the second capacitor line 120 includes a plurality of LSB capacitors. Both, capacitors of the first capacitor line 110 and capacitors of the second capacitor line 120 are successively arranged in powers of two of a basic capacitance C.

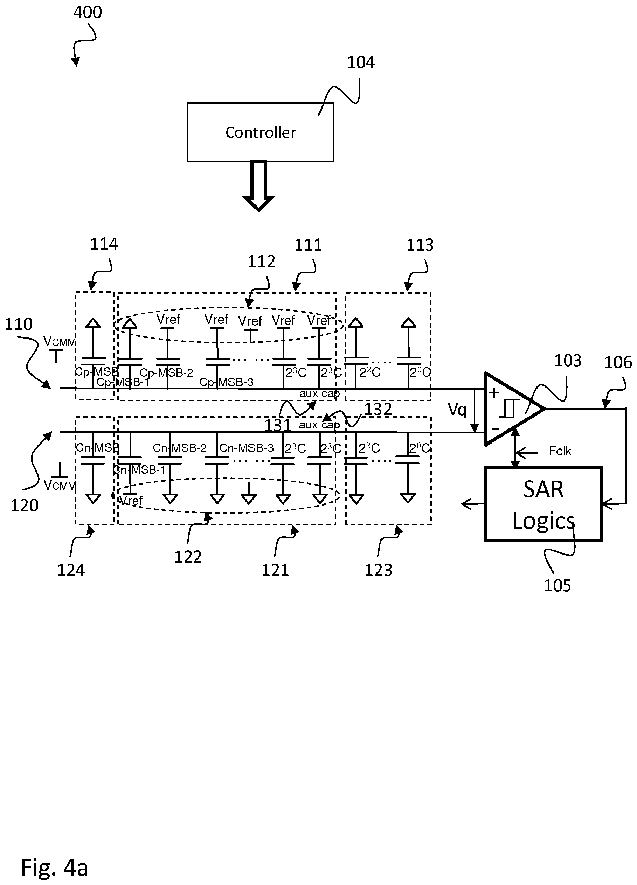

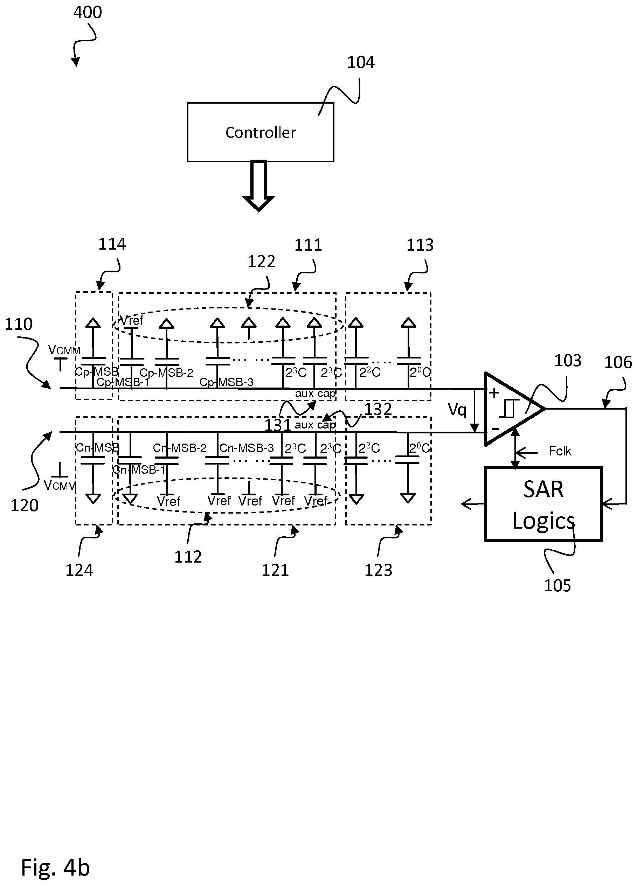

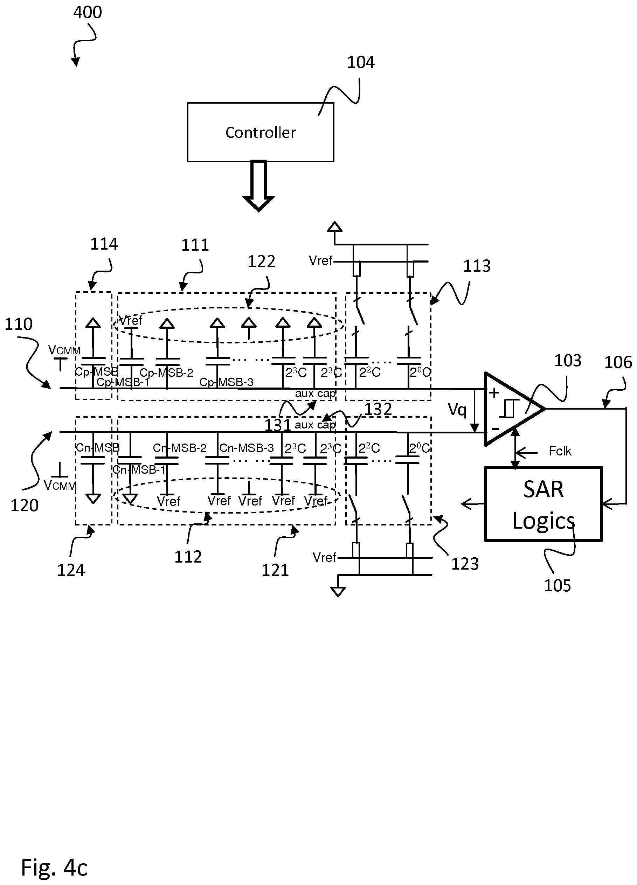

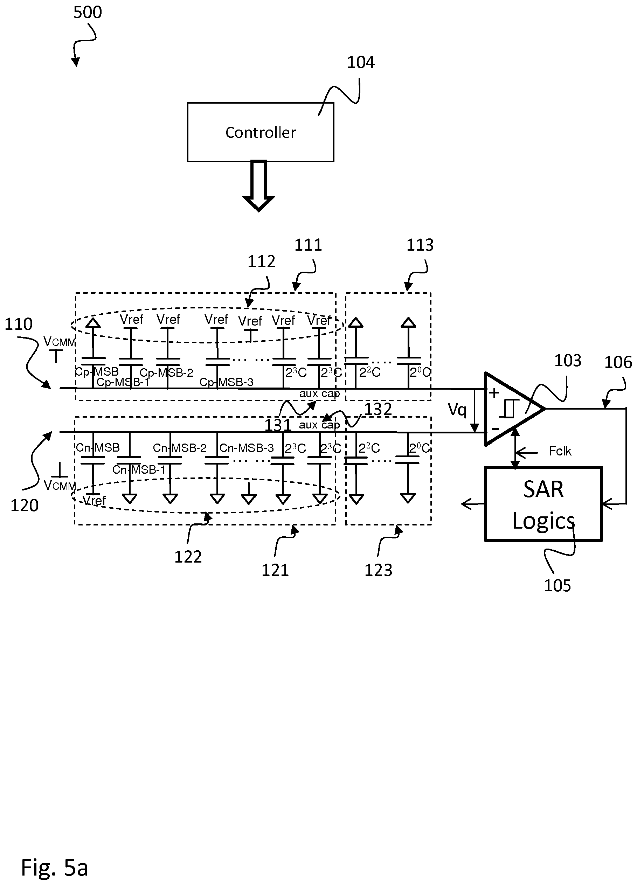

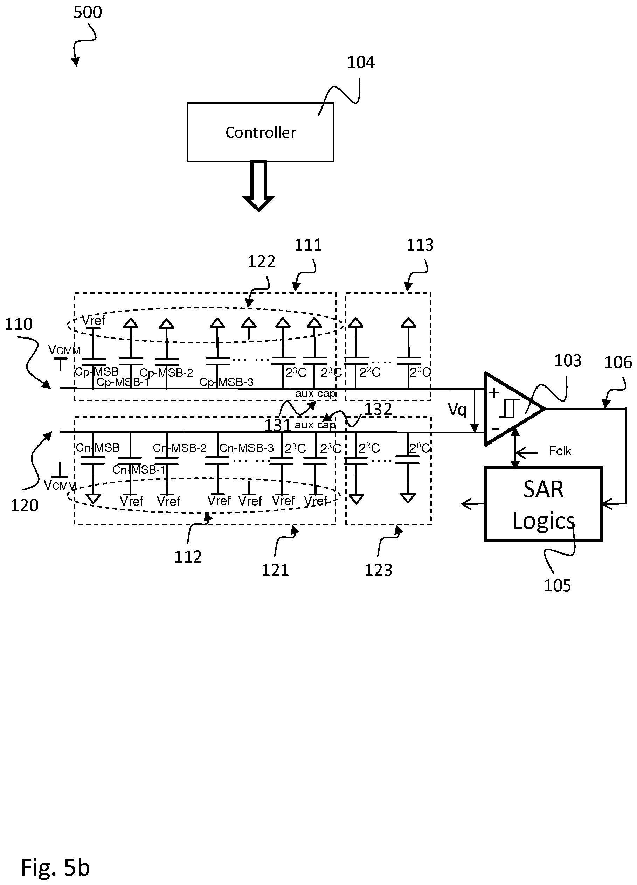

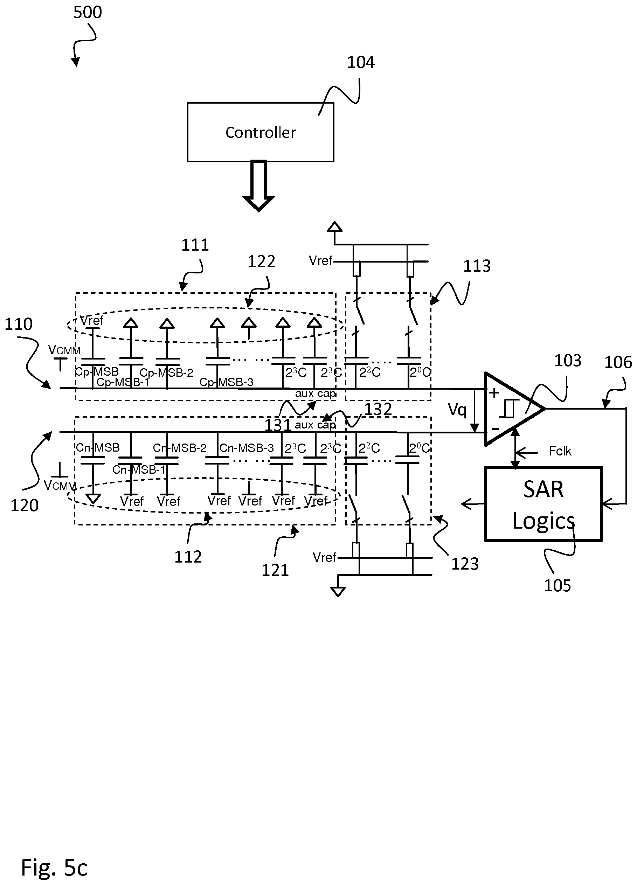

In this implementation, the first part 111 of the first capacitor line 110 includes capacitors Cp-MSB-2 down to $2^3$ C and additionally the auxiliary capacitor $2^3$ C, 131, i.e. the first part 111 of the first capacitor line 110 includes most but not all of the most significant bit (MSB) capacitors of the first capacitor line 110. The two upper MSB capacitors Cp-MSB and Cp-MSB-1 are not included in the first part 111, instead these capacitors are included in a third part 114 of the first capacitor line 110 as described below with respect to Figures 4 and 5. The first part 111 only includes MSB capacitors but no LSB capacitors. The LSB capacitors $2^2$ C, $2^1$ C and $2°$ C are included in a second part 113 of the first capacitor line 110.

Similarly, the corresponding first part 121 of the second capacitor line 120 includes capacitors Cn-MSB-2 down to $2^3$ C and additionally the auxiliary capacitor $2^3$ C, 132, i.e. the first part 121 of the second capacitor line 120 includes most but not all of the most significant bit (MSB) capacitors of the second capacitor line 120. The two upper MSB capacitors Cn-MSB and Cn-MSB-1 are not included in the first part 121, instead these capacitors are included in a third part 124 of the second capacitor line 120 as described below with respect to Figures 4 and 5. The first part 121 only includes MSB capacitors but no LSB capacitors. The LSB capacitors $2^2$ C, $2^1$ C and $2°$ C are included in a second part 123 of the second capacitor line 120.

Note that the first part 121 of the second capacitor line 120 includes the same number of capacitors which have the same capacitance than the first part 111 of the first capacitor line 110, therefore, the first part 121 of the second capacitor line 120 is denoted as the corresponding first part which corresponds to the first part 111 of the first capacitor line 110. In the same manner, the second part 123 of the second capacitor line 120 includes the same number of capacitors which have the same capacitance than the second part 113 of the first capacitor line 110, therefore, the second part 123 of the second capacitor line 120 is denoted as the corresponding second part which corresponds to the second part 113 of the first capacitor line 110. The same relation holds for the third part 124 of the second capacitor line 120 in relation to the third part 114 of the first capacitor line 110.

The calibratable ADC 300 further includes a logic circuit 105 that is coupled to a binary output terminal 106 of the comparator 103. The logic circuit 105 adjusts the second part 113 of the first capacitor line 110 and the corresponding second part 123 of the second capacitor line 120 based on a binary search, for example based on successive approximation reregistering (SAR).

Fig. 3b shows a block diagram illustrating the calibratable ADC 300 during a second calibration phase.

In this second phase, the controller 104 drives the first part 111 of the first capacitor line 110 with the second voltage pattern 122 and the corresponding first part 121 of the second capacitor line 120 with the first voltage pattern 112 in order to generate a comparator input voltage Vq between the input terminals +,- of the comparator 103. The comparator input voltage Vq may be an addition of the voltages at the capacitors of both capacitor lines 110, 120 applied to the comparator 103 in phase 1 as shown in Figure 3a and phase 2 as shown in Figure 3b.

Fig. 3c shows a block diagram illustrating the calibratable ADC 300 during a third calibration phase.

In the third calibration phase, the controller 104 adjusts the second part 113 of the first capacitor line 110 and the corresponding second part 123 of the second capacitor line 120 in order to capture a residual voltage as calibration value. The residual voltage corresponds to the comparator input voltage Vq, as sampled at the end of phase 2. The adjustment may be performed by applying the SAR logics circuit 105 to the second parts 113, 123 of both capacitor lines 110, 120. A SAR algorithm as described above with respect to Figure 1 may be applied to the two second parts 113, 123 which include the LSB capacitors with the lowest capacitances, in this example the values $2^2$C, $2^1$C and $2°$C.

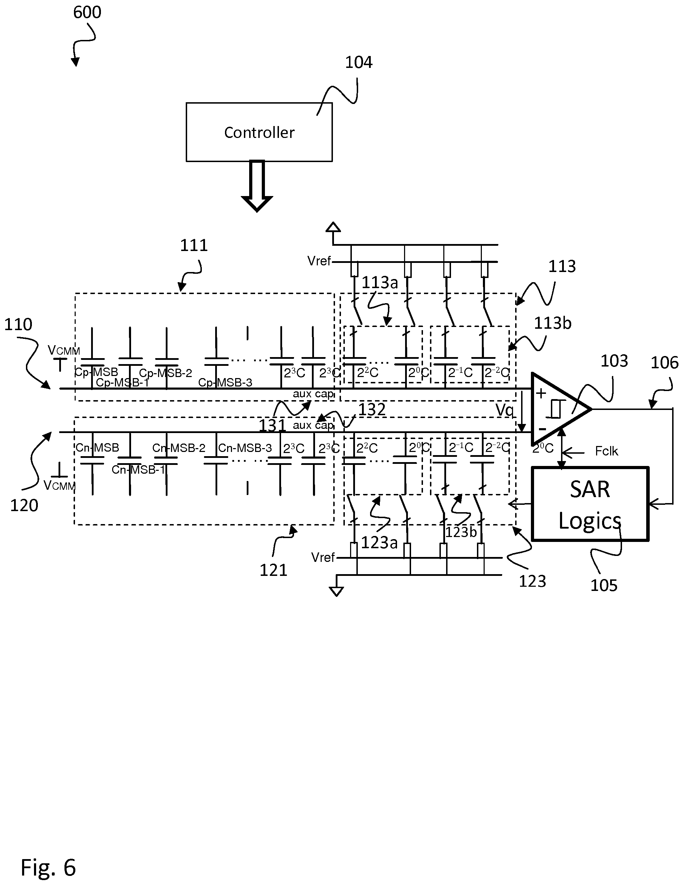

In another implementation form, e.g. as described below with respect to Fig. 6, the second parts 113, 123 may be extended by some additional capacitors which results in a more accurate result. In a further implementation form, the second parts 113, 123 may be reduced by some of their capacitors, for example by the LSB capacitors $2°$C which results in a less accurate result.

Fig. 4a shows a block diagram illustrating a calibratable ADC 400 according to a second implementation form during a first calibration phase.

The ADC 400 corresponds to the ADC 300 as described above with respect to Figures 3a, 3b and 3c. The difference to the implementation of Figures 3a, 3b and 3c is that the first part 111 of the first capacitor line 110 is extended by one additional capacitor, that is, capacitor Cp-MSB-1 and that the corresponding first part 121 of the second capacitor line 120 is extended by one additional capacitor, that is, capacitor Cn-MSB-1.

Further difference is that the first voltage pattern 112 includes the first reference voltage Vref that is coupled to capacitors Cp-MSB-2 to $2^3$ C, i.e. to one more capacitor (Cp-MSB-2) than in the implementation of Figure 3, and additionally to auxiliary capacitor $2^3$ C, 131. The first voltage pattern 112 further includes the second reference voltage (for example Ground) that is now coupled to capacitor Cp-MSB-1. The second voltage pattern 122 includes the second reference voltage, e.g., Ground that is coupled to capacitors Cn-MSB-2 to $2^3$ C, i.e. to one more capacitor (Cn-MSB-2) than in the implementation of Figure 3, and additionally to auxiliary capacitor $2^3$ C, 132. The second voltage pattern 122 further includes the first reference voltage Vref that is now coupled to capacitor Cn-MSB-1.

That means, the first parts 111, 121 of both capacitor lines 110, 120 of the ADC 400 of Figure 4a are extended towards one MSB capacitor (Cp-MSB-1 and Cn-MSB-1) with respect to the first parts 111, 121 of both capacitor lines 110, 120 of the ADC 300 of Figure 3a, 3b and 3c. These two MSB capacitors Cp-MSB-1 and Cn-MSB-1 are taken from the third parts 114, 124 of both capacitor lines 110, 120 of the ADC 300.

In the implementation of Figure 4a describing the first phase, the controller 104 assigns an MSB capacitor from the third part 114 of the first capacitor line 110 to the first part 111 of the first capacitor line 110 and assigns an MSB capacitor from the third part 124 of the second capacitor line 120 to the first part 121 of the second capacitor line 120.

The MSB capacitor Cp-MSB-1 of the third part 114 assigned to the first part 111 of the first capacitor line 110 is an LSB capacitor with respect to the other MSB capacitors (i.e. in this implementation only Cp-MSB) of the third part 114 of the first capacitor line 110. Analogously, the MSB capacitor Cn-MSB-1 of the third part 124 assigned to the first part 121 of the second capacitor line 120 is an LSB capacitor with respect to the other MSB capacitors (i.e. in this implementation only Cn-MSB) of the third part 124 of the second capacitor line 120.

The controller 104 then repeats the driving of the first parts 111, 121 of the first and second capacitor lines 110, 120 with the respective first and second voltage patterns 112, 122.

When the first part 111 of the first capacitor line 110 is driven with the first voltage pattern 112 and the corresponding first part 121 of the second capacitor line 120 is driven with the second voltage pattern 122, the capacitor Cp-MSB of the third part 114 of the first capacitor line 110 and the capacitor Cn-MSB of the corresponding third part 124 of the second capacitor line 120 are connected to a common voltage called VCMM via a switch (not illustrated in the figure) in order to sample the voltage patterns 112, 122 to the capacitors on the first parts 111, 121.

Fig. 4b shows a block diagram illustrating the calibratable ADC 400 during a second calibration phase.

In this second phase, the controller 104 drives the (extended) first part 111 of the first capacitor line 110 with the (extended) second voltage pattern 122 and the corresponding (extended) first part 121 of the second capacitor line 120 with the (extended) first voltage pattern 112 in order to generate a comparator input voltage Vq between the input terminals +,- of the comparator 103. The comparator input voltage Vq may be an addition of the voltages at the capacitors of both capacitor lines 110, 120 applied to the comparator 103 in phase 1 as shown in Figure 4a and phase 2 as shown in Figure 4b.

That means, the controller 104 repeats the driving of the first parts 111, 121 of the first and second capacitor lines 110, 120 with the respective second and first voltage patterns 122, 112; i.e. the inverse voltage pattern with respect to Figure 4a.

Fig. 4c shows a block diagram illustrating the calibratable ADC 400 during a third calibration phase.

In the third calibration phase, the controller 104 adjusts the second part 113 of the first capacitor line 110 and the corresponding second part 123 of the second capacitor line 120 in order to capture a second residual voltage as calibration value. The second residual voltage corresponds to the comparator input voltage Vq, as sampled at the end of phase 2. The adjustment may be performed by applying the SAR logics circuit 105 to the second parts 113, 123 of both capacitor lines 110, 120. A SAR algorithm as described above with respect to Figure 1 may be applied to the two second parts 113, 123 which include the LSB capacitors with the lowest capacitances, in this example the values $2^2$C, $2^1$C and $2°$C.

In the implementation of Fig. 4c the second parts 113, 123 are unchanged with respect to the implementation of Fig. 3. In another implementation form, e.g. as described below with respect to Fig. 6, the second parts 113, 123 may be extended by some additional capacitors which results in a more accurate result. In a further implementation form, the second parts 113, 123 may be reduced by some of their capacitors, for example by the LSB capacitors $2°$C which results in a less accurate result.

Fig. 5a shows a block diagram illustrating a calibratable ADC 500 according to a third implementation form during a first calibration phase.

The ADC 500 corresponds to the ADC 400 as described above with respect to Figures 4a, 4b and 4c. The difference to the implementation of Figures 4a, 4b and 4c is that the first part 111 of the first capacitor line 110 is extended by a further additional capacitor, that is, capacitor Cp-MSB and that the corresponding first part 121 of the second capacitor line 120 is extended by a further additional capacitor, that is, capacitor Cn-MSB.

Further difference is that the first voltage pattern 112 includes the first reference voltage Vref that is coupled to capacitors Cp-MSB-1 to $2^3$ C, i.e. to one more capacitor (Cp-MSB-1) than in the implementation of Figure 4, and additionally to auxiliary capacitor $2^3$ C, 131. The first voltage pattern 112 further includes the second reference voltage (for example Ground) that is now coupled to capacitor Cp-MSB. The second voltage pattern 122 includes the second reference voltage, e.g., Ground that is coupled to capacitors Cn-MSB-1 to $2^3$ C, i.e. to one more capacitor (Cn-MSB-1) than in the implementation of Figure 4, and additionally to auxiliary capacitor $2^3$ C, 132. The second voltage pattern 122 further includes the first reference voltage Vref that is now coupled to capacitor Cn-MSB.

That means, the first parts 111, 121 of both capacitor lines 110, 120 of the ADC 400 of Figure 4a are extended towards one MSB capacitor (Cp-MSB and Cn-MSB) with respect to the first parts 111, 121 of both capacitor lines 110, 120 of the ADC 400 of Figure 4a, 4b and 4c. These two MSB capacitors Cp-MSB and Cn-MSB are taken from the third parts 114, 124 of both capacitor lines 110, 120 of the ADC 400. In the implementation of Figure 5, all capacitors of the capacitor lines 110, 120 are now included in the first or second parts 111, 121, 113, 123 such that no third parts are existing anymore.

In the implementation of Figure 5a describing the first phase, the controller 104 assigns an MSB capacitor from the third part 114 of the first capacitor line 110 (see Figure 4) to the first part 111 of the first capacitor line 110 and assigns an MSB capacitor from the third part 124 of the second capacitor line 120 (see Figure 4) to the first part 121 of the second capacitor line 120. In the implementation of Fig. 5, the assigned MSB capacitors are the both highest MSB capacitors Cp-MSB and Cn-MSB of both capacitor lines 110, 120, i.e. the capacitors having the highest capacitances.

The controller 104 then repeats the driving of the first parts 111, 121 of the first and second capacitor lines 110, 120 with the respective first and second voltage patterns 112, 122.

When the first part 111 of the first capacitor line 110 is driven with the first voltage pattern 112 and the corresponding first part 121 of the second capacitor line 120 is driven with the second voltage pattern 122, the capacitors Cp-MSB, Cp-MSB-1 of the third part 114 of the first capacitor line 110 and the capacitors Cn-MSB, Cn-MSB-1 of the corresponding third part 124 of the second capacitor line 120 are connected to a common voltage called VCMM via a switch (not illustrated in the figure) in order to sample the voltage patterns 112, 122 to the capacitors on the first parts 111, 121.

Fig. 5b shows a block diagram illustrating the calibratable ADC 500 during a second calibration phase.

In this second phase, the controller 104 drives the (further extended) first part 111 of the first capacitor line 110 with the (further extended) second voltage pattern 122 and the corresponding (further extended) first part 121 of the second capacitor line 120 with the (further extended) first voltage pattern 112 in order to generate a comparator input voltage Vq between the input terminals +,- of the comparator 103. The comparator input voltage Vq may be an addition of the voltages at the capacitors of both capacitor lines 110, 120 applied to the comparator 103 in phase 1 as shown in Figure 5a and phase 2 as shown in Figure 5b.

That means, the controller 104 repeats the driving of the first parts 111, 121 of the first and second capacitor lines 110, 120 with the respective second and first voltage patterns 122, 112; i.e. the inverse voltage pattern with respect to Figure 5a.

Fig. 5c shows a block diagram illustrating the calibratable ADC 500 during a third calibration phase.

In the third calibration phase, the controller 104 adjusts the second part 113 of the first capacitor line 110 and the corresponding second part 123 of the second capacitor line 120 in order to capture a third residual voltage as calibration value. The third residual voltage corresponds to the comparator input voltage Vq, as sampled at the end of phase 2. The adjustment may be performed by applying the SAR logics circuit 105 to the second parts 113, 123 of both capacitor lines 110, 120. A SAR algorithm as described above with respect to Figure 1 may be applied to the two second parts 113, 123 which include the LSB capacitors with the lowest capacitances, in this example the values $2^2$C, $2^1$C and $2^0$C.

In the implementation of Fig. 5c the second parts 113, 123 are unchanged with respect to the implementations of Fig. 3 or Fig. 4. In another implementation form, e.g. as described below with respect to Fig. 6, the second parts 113, 123 may be extended by some additional capacitors which results in a more accurate result. In a further implementation form, the second parts 113, 123 may be reduced by some of their capacitors, for example by the LSB capacitors $2_0$C which results in a less accurate result.

The controller 104 may set the calibration value based on the residual voltage obtained in the implementation of Fig. 3c, the second residual voltage obtained in the implementation of Fig. 4c and the third residual voltage obtained in the implementation of Fig. 5c. that means, the implementations of Figures 3, 4 and 5 may be sequentially performed to obtain the residual voltage, the second residual voltage and the third residual voltage.

The ADC 300, 400, 500 may include a memory or data storage for storing data generated in each repetition of driving the first parts 111, 121 and adjusting the second parts 113, 123. The calibration value may be set as a function of the stored data and an offset of the comparator 103, e.g. as described in the following. The calibration value may be applied to a normal operation of the ADC 300, 400, 500.

As illustrated in the three phases depicted in Figures 3, 4 and 5, by using the disclosed technique the mismatch errors on few highest MSB capacitors are obtained and digitized by using the same ADC but with only few of its LSBs.

Therefore, no external predefined inputs such as ramp are needed nor a high quality auxiliary ADC is required. The presented scheme is based on the fact that the capacitor mismatch in MSB capacitors are higher (and hence more critical) than the ones in LSB capacitors in the same ADC. This can be proved by writing the Gaussian distribution of the mismatch errors between the capacitors. Hence, if the MSB's mismatch is calculated and then calibrated in digital domain, the effective resolution of the ADC can be increased.

The disclosed scheme is not limited to this specific SAR ADC as illustrated in Figures 3, 4 and 5 and can be used in any type of SAR ADC with capacitive DAC.

Figures 3, 4 and 5 are an exemplary implementation for a calibratable ADC, e.g. for a 12bit differential ADC as shown in Figure 1. The error of top MSBs can be found and measured using the lower 3 LSBs of the same ADCs. Hence, many errors such as Vref variations, gain etc will not affect the process. This is due to the fact that the ADC top MSB capacitors are calibrated against the LSBs of the same ADC with no specific input signal nor a separate ADC.

Figures 3a, 3b and 3b show the three phases of error sampling and measuring for the MSB-2 capacitors. Note that MSB-1 and MSB capacitors are all ground in both phases. As shown in Figures 3a and 3b, the first 3 LSBs will be connected to ground in both phases 1 and 2. Instead, the auxiliary capacitor 131, 132 will be used that covers the dynamic range of the first 3LSBs.

Assuming no offset voltage for the comparator, at the end of phase 2 (see Figure 3b), the input of the comparator is:

$$V_q = V_{ref}\left\{\frac{C_{p-MSB-2}-\sum_{i=3}^{MSB-3}C_{p-i}-C_{auxp}}{C_{p-total}} + \frac{C_{n-MSB-2}-\sum_{i=3}^{MSB-3}C_{n-i}-C_{auxn}}{C_{n-total}}\right\} \quad (1)$$

Ideally, $\frac{C_{p-MSB-2}-\sum_{i=3}^{MSB-3}C_{p-i}-C_{auxp}}{C_{p-total}} = 0$ and $\frac{C_{n-MSB-2}-\sum_{i=3}^{MSB-3}C_{n-i}-C_{auxn}}{C_{n-total}} = 0$ for a binary based capacitive DAC. Assuming there is an error in MSB-2 capacitors, at the end of phase 2, the input of the comparator is $V_q = (e_{MSB-2})lsb$ where $e_{MSB-2}$ is the total error of the MSB-2 capacitors.

Consequently, the SAR algorithm will start its operation to digitize the comparator's input by using only the first 3 LSBs while the rest of the switches are kept the same as their status in phase 2 as depicted in Figure 3c. If the comparator has an offset of *ofst in terms of lsb,* the result is $D_{out2} = e_{MSB-2} + ofst$. Calculating the offset of the comparator is an easy task and may be done prior to the capacitor mismatch calibration.

As depicted in Figure 4, the same procedure can be used for MSB-1 capacitances. Only $C_{MSB}$ will be kept to ground in all three phases. The digital result at the end of phase 3 is: $D_{out1} = e_{MSB-1} - e_{MSB-2} + ofst$. As can be seen in Figure 4, calculation of the MSB-1 error will depend on the value of MSB-3 capacitance and hence the term $e_{MSB-2}$ is present in $D_{out1}$ digital read.

Same procedure will be deployed for the MSB capacitance. The digital result at the end of phase 3 therefore is: $D_{out0} = e_{MSB} - e_{MSB-1} - e_{MSB-1} + ofst$. The calculation of the MSB error depends on the value of MSB-2 and MSB-1 capacitance and hence the term $e_{MSB-2}$ and $e_{MSB-1}$ are present in $D_{out0}$ digital read. Table 1 details the summary of the error calculation at each stage.

| Digital Read | MSB-2 :$D_{out2}$ | MSB-1 :$D_{out1}$ | MSB :$D_{out0}$ |
|---|---|---|---|
| Errors | $e_{MSB-2}=D_{out2}- ofst$ | $e_{MSB-1} = e_{MSB-2}+D_{out1}- ofst$ | $e_{MSB}= e_{MSB-2}+e_{MSB-1} +D_{out0}- ofst$ |

Table 1: Summary of the error calculations

Fig. 6 shows a block diagram illustrating a calibratable ADC 600 according to a fourth implementation form during a third calibration phase.

As an option, in order to reduce the truncation errors while doing the computation in the calibration mode, few (here 2) more bits cap 113b, 123b can be added to the LSB side, i.e. the second parts 113, 123 of the capacitor lines 110, 120 as shown in Figure 6. This is an example and there are other ways of doing this. For example, by using a fraction of reference on the LSB capacitor or by way of averaging when the level of noise is bigger than one LSB.

The present disclosure also supports a calibration method for calibrating an ADC, for example the ADC 300, 400, 500, 600 described above with respect to Figures 3 to 6.

The method includes: driving a first part 111 of the first capacitor line 110 with a first voltage pattern 112 and a corresponding first part 121 of the second capacitor line 120 with a second voltage pattern 122 in order to sample the voltage patterns to the capacitors of the first part 111 of the first capacitor line 110 and the corresponding first part 121

of the second capacitor line 120 respectively.

The method further includes: driving the first part 111 of the first capacitor line 110 with the second voltage pattern 122 and the corresponding first part 121 of the second capacitor line 120 with the first voltage pattern 112 in order to generate a comparator input voltage Vq between the input terminals +,- of the comparator 103.

The method further includes: adjusting a second part 113 of the first capacitor line 110 and a corresponding second part 123 of the second capacitor line 120 in order to capture a residual voltage, which corresponds to the comparator input voltage Vq, as calibration value.

The method may further include: adjusting the second part 113 of the first capacitor line 110 and the corresponding second part 123 of the second capacitor line 120 based on a binary search, in particular based on successive approximation reregistering (SAR).

The method may further include: inverting the first voltage pattern by exchanging the first reference voltage Vref with the second reference voltage Vgnd and vice versa to obtain the second voltage pattern.

The method may further include: utilizing the first auxiliary capacitor 131 and the second auxiliary capacitor 132 as redundancy steps in a normal operation of the ADC when the ADC is calibrated.

The method may further include: assigning an MSB capacitor from the third part 114 of the first capacitor line 110 to the first part 111 of the first capacitor line 110; assigning an MSB capacitor from the third part 124 of the second capacitor line 120 to the first part 121 of the second capacitor line 120; repeating the driving of the first parts 111, 121 of the first and second capacitor lines 110, 120 with the respective first and second voltage patterns 112, 122; repeating the adjusting of the second parts 113, 123 of the first and second capacitor lines 110, 120 in order to capture a second residual voltage; and setting the calibration value based on the residual voltage and the second residual voltage.

The method may further include: assigning a further MSB capacitor of the third part 114 of the first capacitor line 110 to the first part 111 of the first capacitor line 110; assigning a further MSB capacitor of the third part 124 of the second capacitor line 120 to the first part 121 of the second capacitor line 120; and repeating the driving of the first parts 111, 121 of the first and second capacitor lines 110, 120 with the respective first and second voltage patterns 112, 122; repeating the adjusting of the second parts 113, 123 of the first and second capacitor lines 110, 120 in order to capture a third residual voltage; and setting the calibration value based on the residual voltage, the second residual voltage and the third residual voltage.

The method may further include: storing data generated in each repetition of driving the first parts 111, 121 and adjusting the second parts 113, 123 in a memory. The method may further include: setting the calibration value as a function of the stored data and an offset of the comparator 103. The method may further include: applying the calibration value to a normal operation of the ADC.

The present disclosure also supports a computer program product including computer executable code or computer executable instructions that, when executed, causes at least one computer to execute the performing and computing steps described herein, in particular the tasks of the controller 104 described above with respect to Figures 3 to 6 and the method described above. Such a computer program product may include a readable non-transitory storage medium storing program code thereon for use by a computer. The program code may perform the method described above.

To the extent that the terms "include", "have", "with", or other variants thereof are used in either the detailed description or the claims, such terms are intended to be inclusive in a manner similar to the term "comprise". Also, the terms "exemplary", "for example" and "e.g." are merely meant as an example, rather than the best or optimal. The terms "coupled" and "connected", along with derivatives may have been used. It should be understood that these terms may have been used to indicate that two elements cooperate or interact with each other regardless whether they are in direct physical or electrical contact, or they are not in direct contact with each other.

This application is intended to cover any adaptations or variations of the specific aspects discussed herein, as long as they fall within the scope of protection provided by the appended claims.

Although the elements in the following claims are recited in a particular sequence with corresponding labeling, unless the claim recitations otherwise imply a particular sequence for implementing some or all of those elements, those elements are not necessarily intended to be limited to being implemented in that particular sequence.

Many alternatives, modifications, and variations will be apparent to those skilled in the art in light of the above teachings. Of course, those skilled in the art readily recognize that there are numerous applications of the invention beyond those described herein. While the present invention has been described with reference to one or more particular embodiments, those skilled in the art recognize that many changes may be made thereto without departing from the scope of the present invention. It is therefore to be understood that within the scope of the appended claims the invention may be practiced otherwise than as specifically described herein.

**Claims**

1. A calibratable Analog-to-Digital Converter (ADC) (300, 400, 500, 600), comprising:

 a comparator (103);
 a first capacitor line (Cp, 110) comprising a plurality of capacitances, a first end of each capacitance being coupled to a first input terminal (+) of the comparator (103), wherein the first capacitor line (110) comprises a first part (111), a second part (113) and a third part (114), wherein the third part (114) of the first capacitor line (110) is composed of MSB capacitors, a second end of each of which are coupled to the second reference voltage (Vgnd);
 a second capacitor line (Cn, 120) comprising a plurality of capacitances, a first end of each capacitance being coupled to a second input terminal (-) of the comparator (103), wherein the second capacitor line (120) comprises a first part (121), a second part (123) and a third part (124), respectively corresponding to the first, second and third parts of the first capacitor line, wherein the third part (124) of the second capacitor line (120) is composed of MSB capacitors, a second end of each of which are coupled to the second reference voltage (Vgnd); and
 a controller (104) configured:

 to drive, in a first calibration phase, a second end of each capacitance in Z the first part (111) of the first capacitor line (110) with a first voltage pattern (112 - Fig. 3a to 3c) and a second end of each capacitance in the corresponding first part (121) of the second capacitor line (120) with a second voltage pattern (122 - Fig. 3a to 3c) and connect the capacitors of the third parts of the first and second capacitor lines to a common voltage via a switch in order to sample the voltage patterns to the capacitors of the first part (111) of the first capacitor line (110) and the corresponding first part (121) of the second capacitor line (120) respectively,
 to drive, in a second calibration phase, the second end of each capacitance in the first part (111) of the first capacitor line (110) with the second voltage pattern (122 - Fig. 3a to 3c) and the second end of each capacitance in the corresponding first part (121) of the second capacitor line (120) with the first voltage pattern (112 - Fig. 3a to 3c) in order to generate a comparator input voltage (Vq) between the input terminals (+,-) of the comparator (103), and
 to adjust, in a third calibration phase, the second part (113) of the first capacitor line (110) and the corresponding second part (123) of the second capacitor line (120) based on a binary search in order to capture a residual voltage, which corresponds to the comparator input voltage (Vq), as a digital calibration value;

 wherein the first voltage pattern (112 - Fig. 3a to 3c) comprises a first reference voltage (Vref) coupled to at least one capacitor of the first part (111, 121) of the respective capacitor line it is driving (110, 120) and a second reference voltage (Vgnd) coupled to at least one other capacitor of the first part (111, 121) of the respective capacitor line it is driving (110, 120)
 wherein the second voltage pattern (122 - Fig. 3a - 3c) comprises the second reference voltage (Vgnd) coupled to the at least one capacitor of the corresponding first part (121, 111) of the respective capacitor line it is driving (120, 110) and the first reference voltage (Vref) coupled to the at least one other capacitor of the corresponding first part (121, 111) of the respective capacitor line it is driving (120, 110);
 wherein the controller (104) is further configured to consecutively:

 assign an MSB capacitor from the third part (114) of the first capacitor line (110) to the first part (111) of the first capacitor line (110) to extend it;
 assign an MSB capacitor from the third part (124) of the second capacitor line (120) to the first part (121) of the second capacitor line (120) to extend it;
 drive the extended first parts (111, 121 - Fig. 4a to 4c) of the first and second capacitor lines (110, 120) with respective extended first and second voltage patterns (112, 122 - Fig. 4a to 4c) repeat the adjusting of the second parts (113, 123) of the first and second capacitor lines (110, 120) in order to capture a second residual voltage; and
 set second digital calibration value based on the residual voltage and the second residual voltage.

2. The calibratable ADC (300, 400, 500, 600) of claim 1, comprising:
 a logic circuit (105) coupled to a binary output terminal (106) of the comparator (103), configured to adjust the second part (113) of the first capacitor line (110) and the corresponding second part (123) of the second capacitor line (120) based on a binary search, in particular based on a successive approximation register (SAR).

3. The calibratable ADC (300, 400, 500, 600) of claim 1 or 2,

   wherein the first part (111) of the first capacitor line (110) comprises a plurality of Most Significant Bit (MSB) capacitors; and
   wherein the corresponding first part (121) of the second capacitor line (120) comprises a plurality of MSB capacitors.

4. The calibratable ADC (300, 400, 500, 600) of one of the preceding claims,

   wherein the second part (113) of the first capacitor line (110) comprises a plurality of Least Significant Bit (LSB) capacitors; and
   wherein the corresponding second part (123) of the second capacitor line (120) comprises a plurality of LSB capacitors.

5. The calibratable ADC (300, 400, 500, 600) of one of the preceding claims,
   wherein both, capacitors of the first capacitor line (110) and capacitors of the second capacitor line (120) are successively arranged such that their capacitance is a power of two multiple of a basic capacitance (C).

6. The calibratable ADC (300, 400, 500, 600) of one of the preceding claims,
   wherein the second voltage pattern (122) is an inverse of the first voltage pattern in which the first reference voltage (Vref) is exchanged with the second reference voltage (Vgnd) and vice versa.

7. The calibratable ADC (300, 400, 500, 600) of one of the preceding claims,

   wherein the first part (111) of the first capacitor line (110) comprises a first auxiliary capacitor (131) having a capacitance that is approximately equal to a sum capacitance of capacitors of the second part (113) of the first capacitor line (110); and
   wherein the first part (121) of the second capacitor line (120) comprises a second auxiliary capacitor (132) having a capacitance that is approximately equal to a sum capacitance of capacitors of the second part (123) of the second capacitor line (120).

8. The calibratable ADC (300, 400, 500, 600) of claim 8,
   wherein the first auxiliary capacitor (131) and the second auxiliary capacitor (132) are redundancy step capacitors for utilization as redundancy steps in a normal operation of the ADC (300, 400, 500, 600) when the ADC(300, 400, 500, 600) is calibrated.

9. The calibratable ADC (300, 400, 500, 600) of one of the preceding claims,

   wherein the MSB capacitor of the third part (114) assigned to the first part (111) of the first capacitor line (110) is an LSB capacitor with respect to the other MSB capacitors of the third part (114) of the first capacitor line (110); and
   wherein the MSB capacitor of the third part (124) assigned to the first part (121) of the second capacitor line (120) is an LSB capacitor with respect to the other MSB capacitors of the third part (124) of the second capacitor line (120).

10. The calibratable ADC (300, 400, 500, 600) of one of the preceding claims, wherein the controller (104) is further configured to consecutively:

    assign a further MSB capacitor of the third part (114) of the first capacitor line (110) to the first part (111) of the first capacitor line (110) to further extend it;
    assign a further MSB capacitor of the third part (124) of the second capacitor line (120) to the first part (121) of the second capacitor line (120) to further extend it; and drive the further extended first parts (111, 121 - Fig. 5a to 5c) of the first and second capacitor lines (110, 120) with the respective further extended first and second voltage patterns (112, 122 - Fig. 5a to 5c)
    repeat the adjusting of the second parts (113, 123) of the first and second capacitor lines (110, 120) in order to capture a third residual voltage; and
    set a third digital calibration value based on the residual voltage, the second residual voltage and the third residual voltage.

11. The calibratable ADC (300, 400, 500, 600) of one of the preceding claims, wherein the controller (104) is further configured:

to store data generated in each repetition of driving the first parts (111, 121) and adjusting the second parts (113, 123) in a memory;
to set the respective digital calibration values as a function of the stored data and an offset of the comparator (103); and
to apply the digital calibration values to a normal operation of the ADC (300, 400, 500, 600).

**Patentansprüche**

1. Kalibrierbarer Analog-/Digitalwandler (Analog-to-Digital-Converter - ADC) (300, 400, 500, 600), umfassend:

einen Komparator (103);
eine erste Kondensatorleitung (Cp, 110), umfassend eine Vielzahl von Kapazitäten, wobei ein erstes Ende jeder Kapazität an eine erste Eingangsklemme (+) des Komparators (103) gekoppelt ist, wobei die erste Kondensatorleitung (110) einen ersten Teil (111), einen zweiten Teil (113) und einen dritten Teil (114) umfasst, wobei der dritte Teil (114) der ersten Kondensatorleitung (110) aus MSB-Kondensatoren besteht, von denen jeweils ein zweites Ende an die zweite Referenzspannung (Vgnd) gekoppelt ist;
eine zweite Kondensatorleitung (Cn, 120), umfassend eine Vielzahl von Kapazitäten, wobei ein erste Ende jeder Kapazität an eine zweite Eingangsklemme (-) des Komparators (103) gekoppelt ist, wobei die zweite Kondensatorleitung (120) einen ersten Teil (121), einen zweiten Teil (123) und einen dritten Teil (124) umfasst, die jeweils dem ersten, zweiten und dritten Teil der ersten Kondensatorleitung entsprechen, wobei der dritte Teil (124) der zweiten Kondensatorleitung (120) aus MSB-Kondensatoren besteht, von denen jeweils ein zweites Ende an die zweite Referenzspannung (Vgnd) gekoppelt ist; und
eine Steuerung (104), die dazu konfiguriert ist:

in einer ersten Kalibrierungsphase ein zweites Ende jeder Kapazität in dem ersten Teil (111) der ersten Kondensatorleitung (110) mit einem ersten Spannungsmuster (112 - Fig. 3a bis 3c) und ein zweites Ende jeder Kapazität in dem entsprechenden ersten Teil (121) der zweiten Kondensatorleitung (120) mit einem zweiten Spannungsmuster (122 - Fig. 3a bis 3c) anzutreiben und die Kondensatoren der dritten Teile der ersten und der zweiten Kondensatorleitung mit einer gemeinsamen Spannung über einen Schalter zu verbinden, um die Spannungsmuster zu den Kondensatoren des ersten Teils (111) der ersten Kondensatorleitung (110) bzw. des entsprechenden ersten Teils (121) der zweiten Kondensatorleitung (120) abzutasten,
in einer zweite Kalibrierungsphase das zweite Ende jeder Kapazität in dem ersten Teil (111) der ersten Kondensatorleitung (110) mit dem zweiten Spannungsmuster (122 - Fig. 3a bis 3c) und das zweite Ende jeder Kapazität in dem entsprechenden ersten Teil (121) der zweite Kondensatorleitung (120) mit dem ersten Spannungsmuster (112 - Fig. 3a bis 3c) anzutreiben, um eine Komparatoreingangsspannung (Vq) zwischen den Eingangsklemmen (+,-) des Komparators (103) zu erzeugen, und
in einer dritten Kalibrierungsphase den zweiten Teil (113) der ersten Kondensatorleitung (110) und den entsprechenden zweiten Teil (123) der zweiten Kondensatorleitung (120) auf Grundlage einer binären Suche anzupassen, um eine Restspannung, die der Komparatoreingangsspannung (Vq) entspricht, als einen digitalen Kalibrierungswert zu erfassen;

wobei das erste Spannungsmuster (112 - Fig. 3a bis 3c) eine erste Referenzspannung (Vref), die an mindestens einen Kondensator des ersten Teils (111, 121) der jeweiligen Kondensatorleitung, die sie antreibt, (110, 120) gekoppelt ist, und eine zweite Referenzspannung (Vgnd), die an mindestens einen anderen Kondensator des ersten Teils (111, 121) der jeweiligen Kondensatorleitung, die sie antreibt, (110, 120) gekoppelt ist, umfasst, wobei das zweite Spannungsmuster (122 - Fig. 3a-3c) die zweite Referenzspannung (Vgnd), die an den mindestens einen Kondensator des entsprechenden ersten Teils (121, 111) der jeweiligen Kondensatorleitung, die sie antreibt, (120, 110) gekoppelt ist, und die erste Referenzspannung (Vref), die an den mindestens einen Kondensator des entsprechenden ersten Teils (121, 111) der jeweiligen Kondensatorleitung, die sie antreibt, (120, 110) gekoppelt ist, umfasst;
wobei die Steuerung (104) ferner dazu konfiguriert ist, nacheinander:

einen MSB-Kondensator aus dem dritten Teil (114) der ersten Kondensatorleitung (110) dem ersten Teil

14

(111) der ersten Kondensatorleitung (110) zuzuweisen, um ihn zu erweitern;

einen MSB-Kondensator aus dem dritten Teil (124) der zweiten Kondensatorleitung (120) dem ersten Teil (121) der zweiten Kondensatorleitung (120) zuzuweisen, um ihn zu erweitern;

die erweiterten ersten Teile (111, 121 - Fig. 4a bis 4c) der ersten und der zweiten Kondensatorleitung (110, 120) mit jeweiligen erweiterten ersten und zweiten Spannungsmustern (112, 122 - Fig. 4a bis 4c) anzutreiben, das Anpassen der zweiten Teile (113, 123) der ersten und der zweiten Kondensatorleitung (110, 120) zu wiederholen, um eine zweite Restspannung zu erfassen; und

einen zweiten digitalen Kalibrierungswert auf Grundlage der Restspannung und der zweiten Restspannung einzustellen.

2. Kalibrierbarer ADC (300, 400, 500, 600) nach Anspruch 1, umfassend:

eine logische Schaltung (105), die an eine binäre Ausgangsklemme (106) des Komparators (103) gekoppelt ist, die dazu konfiguriert ist, den zweiten Teil (113) der ersten Kondensatorleitung (110) und den entsprechenden zweiten Teil (123) der zweiten Kondensatorleitung (120) auf Grundlage einer binären Suche, insbesondere auf Grundlage eines sukzessiven Approximationsregisters (SAR), anzupassen.

3. Kalibrierbarer ADC (300, 400, 500, 600) nach Anspruch 1 oder 2, wobei der erste Teil (111) der ersten Kondensatorleitung (110) eine Vielzahl von Höchstwertiges-Bit-Kondensatoren (Most Significant Bit capacitors - MSB capacitors) umfasst; und wobei der entsprechende erste Teil (121) der zweiten Kondensatorleitung (120) eine Vielzahl von MSB-Kondensatoren umfasst.

4. Kalibrierbarer ADC (300, 400, 500, 600) nach einem der vorangehenden Ansprüche, wobei der zweite Teil (113) der ersten Kondensatorleitung (110) eine Vielzahl von Niedrigstwertiges-Bit-Kondensatoren (Least Significant Bit capacitors - LSBcapacitors) umfasst; und

wobei der entsprechende zweite Teil (123) der zweiten Kondensatorleitung (120) eine Vielzahl von LSB-Kondensatoren umfasst.

5. Kalibrierbarer ADC (300, 400, 500, 600) nach einem der vorangehenden Ansprüche,

wobei sowohl Kondensatoren der ersten Kondensatorleitung (110) als auch Kondensatoren der zweiten Kondensatorleitung (120) derart aufeinanderfolgend angeordnet sind, dass ihre Kapazität eine Leistung eines Zweifachen einer Grundkapazität (C) ist.

6. Kalibrierbarer ADC (300, 400, 500, 600) nach einem der vorangehenden Ansprüche, wobei das zweite Spannungsmuster (122) eine Umkehrung des ersten Spannungsmusters ist, bei der die erste Referenzspannung (Vref) mit der zweiten Referenzspannung (Vgnd) vertauscht ist und umgekehrt.

7. Kalibrierbarer ADC (300, 400, 500, 600) nach einem der vorangehenden Ansprüche,

wobei der erste Teil (111) der ersten Kondensatorleitung (110) einen ersten Hilfskondensator (131) umfasst, der eine Kapazität aufweist, die etwa gleich einer Summenkapazität von Kondensatoren des zweiten Teils (113) der ersten Kondensatorleitung (110) ist; und

wobei der erste Teil (121) der zweiten Kondensatorleitung (120) einen zweiten Hilfskondensator (132) umfasst, der eine Kapazität aufweist, die etwa gleich einer Summenkapazität von Kondensatoren des zweiten Teils (123) der zweiten Kondensatorleitung (120) ist.

8. Kalibrierbarer ADC (300, 400, 500, 600) nach Anspruch 8, wobei der erste Hilfskondensator (131) und der zweite Hilfskondensator (132) Redundanzschrittkondensatoren zur Verwendung als Redundanzschritte in einem normalen Betrieb des ADC (300, 400, 500, 600) sind, wenn der ADC (300, 400, 500, 600) kalibriert wird.

9. Kalibrierbarer ADC (300, 400, 500, 600) nach einem der vorangehenden Ansprüche,

wobei der MSB-Kondensator des dritten Teils (114), der dem ersten Teil (111) der ersten Kondensatorleitung (110) zugewiesen ist, ein LSB-Kondensator in Bezug auf die anderen MSB-Kondensatoren des dritten Teils (114) der ersten Kondensatorleitung (110) ist; und

wobei der MSB-Kondensator des dritten Teils (124), der dem ersten Teil (121) der zweiten Kondensatorleitung (120) zugewiesen ist, ein LSB-Kondensator in Bezug auf die anderen MSB-Kondensatoren des dritten Teils (124) der zweiten Kondensatorleitung (120) ist.

**10.** Kalibrierbarer ADC (300, 400, 500, 600) nach einem der vorangehenden Ansprüche, wobei die Steuerung (104) ferner dazu konfiguriert ist, nacheinander:

einen weiteren MSB-Kondensator des dritten Teils (114) der ersten Kondensatorleitung (110) dem ersten Teil (111) der ersten Kondensatorleitung (110) zuzuweisen, um ihn weiter zu erweitern;
einen weiteren MSB-Kondensator des dritten Teils (124) der zweiten Kondensatorleitung (120) dem ersten Teil (121) der zweiten Kondensatorleitung (120) zuzuweisen, um ihn weiter zu erweitern; und
die weiter erweiterten ersten Teile (111, 121 - Fig. 5a bis 5c) der ersten und der zweiten Kondensatorleitung (110, 120) mit den jeweiligen weiter erweiterten ersten und zweiten Spannungsmustern (112, 122 - Fig. 5a bis 5c) anzutreiben, das Anpassen der zweiten Teile (113, 123) der ersten und der zweiten Kondensatorleitung (110, 120) zu wiederholen, um eine dritte Restspannung zu erfassen; und
einen dritten digitalen Kalibrierungswert auf Grundlage der Restspannung, der zweiten Restspannung und der dritten Restspannung einzustellen.

**11.** Kalibrierbarer ADC (300, 400, 500, 600) nach einem der vorangehenden Ansprüche, wobei die Steuerung (104) ferner dazu konfiguriert ist:

in jeder Wiederholung des Antreibens der ersten Teile (111, 121) und des Anpassens der zweiten Teile (113, 123) erzeugte Daten in einem Speicher zu speichern;
die jeweiligen digitalen Kalibrierungswerte als eine Funktion der gespeicherten Daten und eines Versatzes des Komparators (103) einzustellen; und
die digitalen Kalibrierungswerte auf eine normalen Betrieb des ADC (300, 400, 500, 600) anzuwenden.

**Revendications**

**1.** Convertisseur analogique-numérique (ADC) étalonnable (300, 400, 500, 600) comprenant :

un comparateur (103) ;
une première ligne de condensateurs (Cp, 110) comprenant une pluralité de capacités, une première extrémité de chaque capacité étant couplée à une première borne d'entrée (+) du comparateur (103), dans lequel la première ligne de condensateurs (110) comprend une première partie (111), une deuxième partie (113) et une troisième partie (114), dans lequel la troisième partie (114) de la première ligne de condensateurs (110) est composée de condensateurs de MSB (bits de poids fort), une seconde extrémité de chacun de ceux-ci étant couplée à la seconde tension de référence (Vgnd) ;
une seconde ligne de condensateurs (Cn, 120) comprenant une pluralité de capacités, une première extrémité de chaque capacité étant couplée à une seconde borne d'entrée (-) du comparateur (103), dans lequel la seconde ligne de condensateurs (120) comprend une première partie (121), une deuxième partie (123) et une troisième partie (124), correspondant respectivement aux première deuxième et troisième parties de la première ligne de condensateurs, dans lequel la troisième partie (124) de la seconde ligne de condensateurs (120) est composée de condensateurs de MSB, une seconde extrémité de chacun de ceux-ci étant couplée à la seconde tension de référence (Vgnd) ; et
un dispositif de commande (104) configuré :

pour attaquer, lors d'une première phase d'étalonnage, une seconde extrémité de chaque condensateur dans la première partie (111) de la première ligne de condensateurs (110) avec un premier motif de tension (112 - Fig. 3a à 3c) et une seconde extrémité de chaque capacité dans la première partie correspondante (121) de la seconde ligne de condensateurs (120) avec un second motif de tension (122 - Fig. 3a à 3c), et coupler les condensateurs des troisièmes parties des première et seconde lignes de condensateurs à une tension commune par l'intermédiaire d'un commutateur afin d'échantillonner les motifs de tension vers les condensateurs de la première partie (111) de la première ligne de condensateurs (110) et la première partie correspondante (121) de la seconde ligne de condensateurs (120) respectivement, pour attaquer, lors d'une deuxième phase d'étalonnage, la seconde extrémité de chaque capacité dans la première partie (111) de la première ligne de condensateurs (110) avec le second motif de tension (122 - Fig. 3a à 3c) et la seconde extrémité de chaque capacité dans la première partie correspondante (121) de la seconde ligne de condensateurs (120) avec le premier motif de tension (112 - Fig. 3a à 3c) afin de générer une tension d'entrée de comparateur (Vq) entre les bornes d'entrée (+,-) du comparateur (103), et
pour ajuster, lors d'une troisième phase d'étalonnage, la deuxième partie (113) de la première ligne de condensateurs (110) et la deuxième partie correspondante (123) de la seconde ligne de condensateurs (120) en fonction d'une recherche binaire afin de capturer une tension résiduelle, qui correspond à la tension d'entrée de comparateur (Vq), à titre de valeur d'étalonnage ;

dans lequel le premier motif de tension (112 - Fig. 3a à 3c) comprend une première tension de référence (Vref) couplée à au moins un condensateur de la première partie (111, 121) de la ligne de condensateur respective qu'il attaque (110, 120) et une seconde tension de référence (Vgnd) couplée à au moins un autre condensateur de la première partie (111, 121) de la ligne de condensateur respective qu'il attaque (110, 120) dans lequel le second motif de tension (122 - Fig. 3a à 3c) comprend la seconde tension de référence (Vgnd) couplée à l'au moins un condensateur de la première partie correspondante (121, 111) de la ligne de condensateur respective qu'il attaque (120, 110) et la première tension de référence (Vref) couplée à l'au moins un autre condensateur de la première partie (121, 111) de la ligne de condensateur respective qu'il attaque (120, 110) ;
dans lequel le dispositif de commande (104) est configuré pour successivement :

attribuer un condensateur de MSB (bit de poids fort) de la troisième partie (114) de la première ligne de condensateurs (110) à la première partie (111) de la première ligne de condensateurs (110) pour l'étendre ;
attribuer un condensateur de MSB de la troisième partie (124) de la seconde ligne de condensateurs (120) à la première partie (121) de la seconde ligne de condensateurs (120) pour l'étendre ;
attaquer les premières parties étendues (111,121 - Fig. 4a à 4c) des première et seconde lignes de condensateurs (110, 120) avec les premier et second motifs de tension étendus respectifs (112, 122 - Fig. 4a à 4c)
répéter l'ajustement des deuxièmes parties (113, 123) des première et seconde lignes de condensateurs (110, 120) afin de capturer une deuxième tension résiduelle ; et
établir une deuxième valeur d'étalonnage numérique en fonction de la tension résiduelle et de la deuxième tension résiduelle.

2. Convertisseur analogique-numérique étalonnable (300, 400, 500, 600) selon la revendication 1, comprenant :
un circuit logique (105) couplé à une borne de sortie binaire (106) du comparateur (103), configuré pour ajuster la deuxième partie (113) de la première ligne de condensateurs (110) et la deuxième partie correspondante (123) de la seconde ligne de condensateurs (120) en fonction d'une recherche binaire, notamment en fonction d'un registre d'approximations successives (SAR) .

3. Convertisseur analogique-numérique étalonnable (300, 400, 500, 600) selon la revendication 1 ou 2,
dans lequel la première partie (111) de la première ligne de condensateurs (110) comprend une pluralité de condensateurs de bit de poids fort (MSB)) ; et
dans lequel la première partie correspondante (121) de la seconde ligne de condensateurs (120) comprend une pluralité de condensateurs de MSB.

4. Convertisseur analogique-numérique étalonnable (300, 400, 500, 600) selon l'une quelconque des revendications précédentes, dans lequel la deuxième partie (113) de la première ligne de condensateurs (110) comprend une pluralité de condensateurs de bit de poids faible (LSB) ; et
dans lequel la deuxième partie correspondante (123) de la seconde ligne de condensateurs (120) comprend une pluralité de condensateurs de LSB.

5. Convertisseur analogique-numérique étalonnable (300, 400, 500, 600) selon l'une des revendications précédentes, dans lequel à la fois des condensateurs de la première ligne de condensateurs (110) et des condensateurs de la seconde ligne de condensateurs (120) sont successivement agencés de sorte que leur capacité soit une puissance de deux multiple d'une capacité de base (C).

6. Convertisseur analogique-numérique étalonnable (300, 400, 500, 600) selon l'une quelconque des revendications précédentes, dans lequel le second motif de tension (122) est un inverse du premier motif de tension dans lequel la première tension de référence (Vref) est échangée avec la seconde tension de référence (Vgnd) et vice-versa.

7. Convertisseur de données analogique-numérique étalonnable (300, 400, 500, 600) selon l'une quelconque des revendications précédentes,
dans lequel la première partie (111) de la première ligne de condensateurs (110) comprend un premier condensateur auxiliaire (131) ayant une capacité qui est approximativement égale à une capacité cumulative des condensateurs de la deuxième partie (113) de la première ligne de condensateurs (110) ; et

dans lequel la première partie (121) de la seconde ligne de condensateurs (120) comprend un second condensateur auxiliaire (132) ayant une capacité qui est approximativement égale à une capacité cumulative des condensateurs de la deuxième partie (123) de la seconde ligne de condensateurs (120).

8. Convertisseur analogique-numérique étalonnable (300, 400, 500, 600) selon la revendication 8,
dans lequel le premier condensateur auxiliaire (131) et le second condensateur auxiliaire (132) sont des condensateurs d'étape de redondance destinés à une utilisation en tant qu'étapes de redondance dans le cadre d'un fonctionnement normal du convertisseur analogique-numérique (300, 400, 500, 600) lorsque le convertisseur analogique-numérique (300, 400, 500, 600) est étalonné.

9. Convertisseur analogique-numérique étalonnable (300, 400, 500, 600) selon l'une quelconque des revendications précédentes, dans lequel le condensateur de MSB de la troisième partie (114) attribué à la première partie (111) de la première ligne de condensateurs (110) est un condensateur de LSB par rapport aux autres condensateurs de MSB de la troisième partie (114) de la première ligne de condensateurs (110) ; et
dans lequel le condensateur de MSB de la troisième partie (124) attribué à la première partie (121) de la seconde ligne de condensateurs (120) est un condensateur de LSB par rapport aux autres condensateurs de MSB de la troisième partie (124) de la seconde ligne de condensateurs (120).

10. Convertisseur analogique-numérique étalonnable (300, 400, 500, 600) selon l'une quelconque des revendications précédentes, dans lequel le dispositif de commande (104) est en outre configuré pour successivement :

   attribuer un autre condensateur de MSB de la troisième partie (114) de la première ligne de condensateurs (110) à la première partie (111) de la première ligne de condensateurs (110) pour l'étendre davantage ;
   attribuer un autre condensateur de MSB de la troisième partie (124) de la seconde ligne de condensateurs (120) à la première partie (121) de la seconde ligne de condensateurs (120) pour l'étendre davantage ; et
   attaquer les premières parties étendues davantage (111,121 - Fig. 5a à 5c) des première et seconde lignes de condensateurs (110, 120) avec les premier et second motifs de tension étendus davantage respectifs (112, 122 - Fig. 5a à 5c) répéter l'ajustement des deuxièmes parties (113, 123) des première et seconde lignes de condensateurs (110, 120) afin de capturer une troisième tension résiduelle ; et
   établir une troisième valeur d'étalonnage numérique en fonction de la tension résiduelle, de la deuxième tension résiduelle et de la troisième tension résiduelle.

11. Convertisseur de données analogique-numérique étalonnable (300, 400, 500, 600) selon l'une des revendications précédentes, dans lequel le dispositif de commande (104) est en outre configuré :

   pour stocker des données générées lors de chaque répétition de l'attaque des premières parties (111, 121) et de l'ajustement des secondes parties (113, 123) dans une mémoire ;
   pour établir les valeurs d'étalonnage numérique respectives comme une fonction des données stockées et un décalage du comparateur (103) ; et
   pour appliquer les valeurs d'étalonnage numérique à un fonctionnement normal du convertisseur analogique-numérique (300, 400, 500, 600).

Fig. 1

200

Fig. 2

Fig. 3a

Fig. 3b

Fig. 3c

Fig. 4a

Fig. 4b

Fig. 4c

Fig. 5a

Fig. 5b

Fig. 5c

600

104

Controller

111

Vref

113a

113

113b

110

$V_{CMM}$

Cp-MSB  Cp-MSB-2  Cp-MSB-3  $2^3C$  $2^3C$  $2^2C$  $2^0C$  $2^{-1}C$  $2^{-2}C$

Cp-MSB-1

aux cap

132

131  aux cap

$V_q$

103  106

+

Cn-MSB  Cn-MSB-2  Cn-MSB-3  $2^3C$  $2^3C$  $2^2C$  $2^0C$  $2^{-1}C$  $2^{-2}C$

Cn-MSB-1

−

$2^0C$  Fclk

$V_{CMM}$

120

SAR
Logics

121

123a  123b

Vref

123

105

Fig. 6

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2013076546 A1
- US 2010079326 A1
- DE 102014200624 B3